# EUROPEAN PATENT APPLICATION

(11) **EP 4 832 678 A1**
(43) Date of publication of application: **28.10.2026**
(21) Application number: 24918187.6
(22) Date of filing: 08.11.2024
(51) Int. Cl.: H05K 7/20

(54) **BATTERY DISTRIBUTION BOX, BATTERY, AND ELECTRIC DEVICE**

(30) Priority: 19.01.2024 CN 202410080889
(71) Applicant: Contemporary Amperex Technology Co., Limited, Ningde, Fujian 352100 (CN)
(72) Inventor: WU, Minghui, Ningde, Fujian 352100 (CN); LIN, Weilong, Ningde, Fujian 352100 (CN); LI, Junrong, Ningde, Fujian 352100 (CN); ZHU, Hao, Ningde, Fujian 352100 (CN)
(74) Representative: Kraus & Lederer PartGmbB
(86) International application number: PCT/CN2024/131030
(87) International publication number: WO 2025/152578

(57) **Abstract**

The present application relates to the field of batteries and provides a battery distribution box, a battery, and an electric device. The battery distribution box provided in the present application comprises a shell, an electrical assembly and a heat dissipation cover plate, wherein an accommodating cavity having an opening is formed in the shell; the electrical assembly is arranged in the accommodating cavity, and the electrical assembly comprises a plurality of electrical elements and conductive connectors connected to the electrical elements; the heat dissipation cover plate is connected to the shell to cover the opening, and the conductive connectors are at least partially in contact with the heat dissipation cover plate to achieve heat conduction. The conductive connectors being in contact with the heat dissipation cover plate enables a simplified manner of connection between the conductive connectors and the cover plate with heat dissipation function, reduced extension length of the conductive connectors, and improved space utilization rate of the battery distribution box.

## Description

### CROSS-REFERENCE TO RELATED APPLICATIONS

This application claims priority to Chinese Patent Application No. 202410080889.2 filed on January 19, 2024 and entitled "BATTERY DISTRIBUTION BOX, BATTERY, AND ELECTRIC DEVICE", which is incorporated herein by reference in its entirety.

### TECHNICAL FIELD

This application relates to the technical field of batteries, and in particular, to a battery distribution box, a battery, and an electric apparatus.

### BACKGROUND

Energy conservation and emission reduction are key to the sustainable development of the automobile industry. Electric vehicles have become an important part of the sustainable development of the automobile industry due to their advantages of energy conservation and environmental protection. For electric vehicles, battery technology is an important factor in their development.

As a core electrical load component of a battery, a battery distribution box withstands the load current of the entire battery. The load current generates a large amount of heat. Since the battery is typically a fully enclosed space, accumulated heat cannot be dissipated in time. In this case, the battery distribution box may be burned, and a fire may even occur. This requires improvement.

### SUMMARY

This application aims to at least solve one of the technical problems in the background technology. To this end, an objective of this application is to provide a battery distribution box, a battery, and an electric apparatus to improve heat dissipation of the battery distribution box.

Embodiments of a first aspect of this application provide a battery distribution box, including a shell, an electrical assembly, and a heat dissipation cover plate; the shell forms an accommodating cavity provided with an opening; the electrical assembly is provided in the accommodating cavity, where the electrical assembly includes a plurality of electrical elements and a conductive connecting member connected to the electrical elements; and the heat dissipation cover plate is connected to the shell to cover the opening, where the conductive connecting member is at least partially in contact with the heat dissipation cover plate to achieve heat conduction.

In the technical solution of the embodiments of this application, the cover plate is implemented as the heat dissipation cover plate, and the conductive connecting member is at least partially in contact with the heat dissipation cover plate to achieve heat conduction. This simplifies the connection manner between the conductive connecting member and the cover plate having a heat dissipation function, reducing an extension length of the conductive connecting member and improving the space utilization of the battery distribution box.

In some embodiments, the conductive connecting member includes a connecting portion and a protruding portion, where the connecting portion is electrically connected to the electrical element, the protruding portion is connected to the connecting portion, the protruding portion protrudes relative to the connecting portion toward a side on which the opening of the shell is located, and the protruding portion is in contact with the heat dissipation cover plate to achieve heat conduction. With the protruding portion, a heat conduction connection is achieved without additionally occupying the space inside the battery distribution box. In this way, the extension structure of the conductive connecting member is simplified.

In some embodiments, the connecting portion is connected to a connection terminal of the electrical element, and the connection terminal is located on a surface of the electrical element close to the opening of the shell. Providing the connection terminal on the surface of the electrical element close to the opening facilitates mounting of various components, especially the conductive connecting member, and reduces manufacture and mounting difficulty of the battery distribution box.

In some embodiments, the connecting portion and the connection terminal are connected by a fastener, and a height of the protruding portion relative to the connecting portion is greater than a height of the fastener on a side of the connecting portion close to the opening of the shell. The height of the protruding portion is limited to avoid structural interference caused by the fastener connection, thereby achieving reliable contact between the protruding portion and the heat dissipation cover plate and improving the reliability of heat dissipation.

In some embodiments, the heat dissipation cover plate includes a heat dissipation portion, and the heat dissipation portion includes a heat dissipation body internally provided with a liquid cooling flow channel and a liquid inlet and a liquid outlet that communicate with the liquid cooling flow channel; where the conductive connecting member is at least partially in contact with the heat dissipation body. Configuring the heat dissipation portion of the heat dissipation cover plate as a liquid cooling assembly improves the effect of heat dissipation and cooling. The heat dissipation portion may also communicate with the liquid cooling assembly of the battery. This significantly reduces the manufacture costs and simplifies control of the heat dissipation cover plate.

In some embodiments, the heat dissipation cover plate further includes a frame, the frame is provided around an outer periphery of the heat dissipation portion, and the frame is detachably connected to the shell. The frame is provided to support the heat dissipation portion and is connected to the shell. In this way, the structure of the heat dissipation portion is simplified, thereby simplifying processing and saving the manufacture costs.

In some embodiments, the heat dissipation portion and the frame are integrally formed. Integration of the heat dissipation portion and the frame reduces the number of components, thereby simplifying the assembly and improving production efficiency.

In some embodiments, the heat dissipation portion is a liquid cooling plate, and the frame is injection molded along an outer periphery of the liquid cooling plate. The injection molding is performed around the liquid cooling plate to obtain the integrated heat dissipation cover plate, so that a tighter connection is formed between the heat dissipation portion and the frame. Without affecting the heat dissipation effect, the weight and manufacture costs of the cover plate are reduced, the structure of the cover plate is simplified, and production efficiency is improved.

In some embodiments, the battery distribution box further includes an insulating layer, and the insulating layer is located on a surface of a side of the heat dissipation cover plate in contact with the conductive connecting member. With the insulating layer, only heat transfer is achieved when the conductive connecting member is in contact with the heat dissipation cover plate, so that the risk of electrical leakage is reduced, and the safety of the battery distribution box is improved to a certain extent.

In some embodiments, the battery distribution box further includes a heat-conducting member, and the heat-conducting member is located between the heat dissipation cover plate and the conductive connecting member for heat conduction. With the heat-conducting member, the contact area between the conductive connecting member and the heat dissipation cover plate is increased, improving the heat conduction efficiency between the conductive connecting member and the heat dissipation cover plate to a certain extent, thereby improving the heat dissipation performance.

In some embodiments, the heat-conducting member is made of an insulating heat-conducting material. The heat-conducting member provides an insulating effect. Therefore, an additional insulating layer is not required, which reduces processes or components.

Embodiments of a second aspect of this application provide a battery, including a battery cell and the battery distribution box in the above embodiments, where the battery distribution box is electrically connected to the battery cell.

Embodiments of a third aspect of this application provide an electric apparatus, including the battery in the above embodiments, where the battery is configured to provide electric energy.

The above description is only an overview of the technical solutions of this application. To more clearly understand the technical means of this application, the technical means may be implemented in accordance with the content of the specification. To make the above and other objectives, features and advantages of this application more obvious and understandable, the specific embodiments of this application are specifically listed below.

### BRIEF DESCRIPTION OF DRAWINGS

In the drawings, unless otherwise specified, the same reference signs throughout the drawings represent same or similar components or elements. These drawings are not necessarily drawn to scale. It should be understood that these drawings only depict some embodiments disclosed according to this application and should not be regarded as limitations to the scope of this application. To more clearly illustrate the technical solutions of the embodiments of this application, the drawings for the embodiments of this application are briefly introduced below. It is clear that the drawings described below are only some embodiments of this application. For those of ordinary skill in the art, other drawings may be obtained based on the drawings without creative efforts.
FIG. 1 is a schematic structural diagram of a vehicle according to some embodiments of this application;
FIG. 2 is a schematic exploded view of a battery according to some embodiments of this application;
FIG. 3 is a schematic exploded view of a battery distribution box according to some embodiments of this application;
FIG. 4 is a schematic structural diagram of an interior of a shell of a battery distribution box according to some embodiments of this application;
FIG. 5 is a schematic structural diagram of a heat dissipation cover plate of a battery distribution box according to some embodiments of this application; and
FIG. 6 is a schematic exploded view of a battery distribution box according to other embodiments of this application.

### Description of reference signs:

vehicle 1000;
battery 100, controller 200, motor 300;
casing 10, first part 11, second part 12;
battery cell 20, battery distribution box 30, shell 310, electrical assembly 320, electrical element 321, conductive connecting member 322, protruding portion 3221, connecting portion 3222, heat dissipation cover plate 330, heat dissipation portion 331, heat dissipation body 3311, liquid inlet 3312, liquid outlet 3313, and frame 332.

### DESCRIPTION OF EMBODIMENTS

The embodiments of the technical solutions of this application are described in detail below with reference to the drawings. The following embodiments are only used to more clearly illustrate the technical solutions of this application, and are therefore only used as examples and cannot be used to limit the protection scope of this application.

Unless otherwise defined, all technical and scientific terms used herein have the same meaning as commonly understood by those skilled in the art of this application; the terms used herein are only for the purpose of describing specific embodiments and are not intended to limit this application; the terms "include" and "have" and any variations thereof in the description and claims of this application and the above drawings are intended to cover non-exclusive inclusion.

In the description of the embodiments of this application, the technical terms such as "first" and "second" are only used to distinguish different objects and cannot be understood as indication or implication of relative importance or implicit indication of a quantity, specific order, or primary-secondary relationship of the indicated technical features. In the description of the embodiments of this application, "plurality" means two or more, unless otherwise clearly and specifically limited.

The reference to "an embodiment" herein means that a specific feature, structure, or characteristic described with reference to the embodiment may be included in at least one embodiment of this application. The appearance of the phrase in various positions in the description does not necessarily refer to the same embodiment, nor is it an independent or alternative embodiment that is mutually exclusive with other embodiments. It is explicitly and implicitly understood by those skilled in the art that the embodiments described herein may be combined with other embodiments.

In the description of the embodiments of this application, the term "and/or" is only a description of an association relationship of associated objects, indicating that three relationships may exist. For example, A and/or B may mean: only A exists, both A and B exist, and only B exists. In addition, the character "/" in this specification generally indicates that the associated objects are in an "or" relationship.

In the description of the embodiments of this application, the term "plurality" means two or more (including two), and similarly, "a plurality of groups" refers to two or more groups (including two groups), and "a plurality of pieces" refers to two or more pieces (including two pieces).

In the description of the embodiments of this application, orientations or positional relationships indicated by the technical terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", or the like are based on the orientation or positional relationships shown in the drawings, and are only for the convenience of describing the embodiments of this application and simplifying the description, and do not indicate or imply that the referred apparatus or element must have a specific orientation, or be constructed and operated in a specific orientation, and therefore cannot be understood as a limitation on the embodiments of this application.

In the description of the embodiments of this application, unless otherwise clearly specified and limited, the technical terms "mount", "connect", "join", "fasten", and the like should be understood in a broad sense. For example, it may refer to a fixed connection, a detachable connection, or integration; a mechanical connection or an electrical connection; a direct connection or an indirect connection through an intermediate medium; or internal communication of two elements or an interaction relationship between two elements. For those of ordinary skill in the art, the specific meanings of the above terms in the embodiments of this application may be understood based on specific circumstances.

From the perspective of current market development, the application of traction batteries are finding increasingly broad applications. Traction batteries are not only used in energy storage power systems such as hydropower, thermal power, wind power and solar power stations, but are also widely used in electric transportation devices such as electric bicycle, electric motorcycle, and electric vehicle, and in many fields such as military equipment and aerospace. With the continuous expansion of the applications of traction batteries, the market demand is increasing.

A battery distribution box is responsible for managing distribution and cut-off of battery current. With the development of battery technology, the demand for batteries in electric apparatuses increases, requiring the battery distribution box to handle increasingly higher currents, which leads to a significant increase in heat generation. In the related art, a liquid cooling plate is arranged at a bottom of the battery distribution box, and a conductive connecting member in the distribution box shell contacts the liquid cooling plate for heat dissipation. Since the liquid cooling plate is at the bottom of the shell, the conductive connecting member needs to be led down to the bottom of the shell to contact the liquid cooling plate, which leads to an increase in a length of the conductive connecting member. This increases costs, and an internal space of the distribution box is occupied, resulting in space waste and increasing difficulty of mounting and manufacture of the distribution box.

To solve the above problems, the embodiments of this application propose a battery distribution box, including a shell, an electrical assembly, and a heat dissipation cover plate; the shell forms an accommodating cavity provided with an opening; the electrical assembly is provided in the accommodating cavity; the electrical assembly includes a plurality of electrical elements and a conductive connecting member connected to the electrical elements; the heat dissipation cover plate is connected to the shell to cover the opening; and the conductive connecting member is at least partially in contact with the heat dissipation cover plate to achieve heat conduction. A cover plate is replaced with a heat dissipation cover plate, and the conductive connecting member contacts the heat dissipation cover plate, so that an extension length of the conductive connecting member is reduced, space utilization of the distribution box is improved, the manufacture costs are lower, and the manufacture is simplified.

The battery cell disclosed in the embodiments of this application may be applied to electric apparatuses such as vehicle, ship or aircraft, but is not limited thereto. A power system of the electric apparatus may be formed by a battery cell, a battery, and the like disclosed in this application.

The embodiments of this application provide an electric apparatus using a battery as a power source. The electric apparatus may be, but is not limited to, a mobile phone, a tablet, a laptop computer, an electric toy, an electric tool, an electric bicycle, an electric vehicle, a ship, a spacecraft, or the like. The electric toy may include a fastened or mobile electric toy, such as a game console, an electric car toy, an electric ship toy, an electric airplane toy, or the like. The spacecraft may include an airplane, a rocket, a space shuttle, a spaceship, or the like.

For the convenience of description, for example, an electric apparatus according to an embodiment of this application is a vehicle 1000 in the following embodiments.

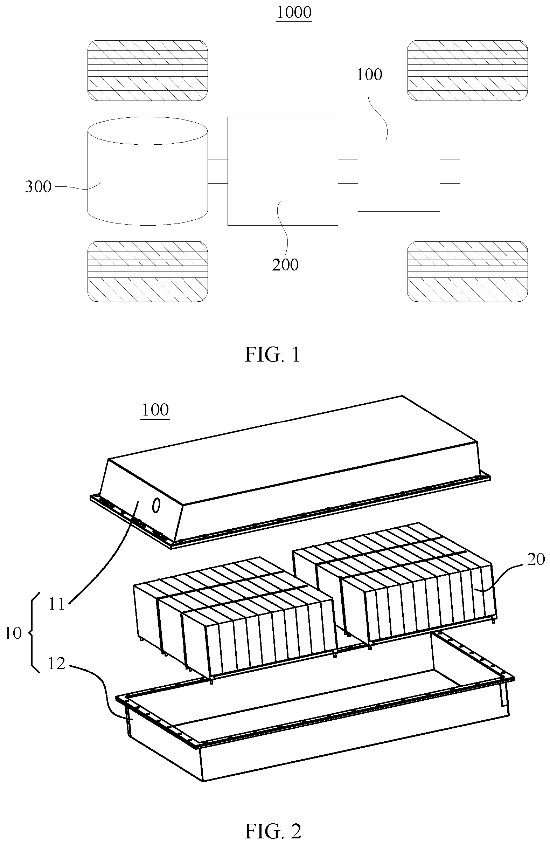

Refer to FIG. 1. FIG. 1 is a schematic structural diagram of a vehicle provided in some embodiments of this application. The vehicle 1000 may be a fuel vehicle, a gas vehicle, or a new energy vehicle. The new energy vehicle may be a pure electric vehicle, a hybrid vehicle, an extended-range vehicle, or the like. A battery 100 is provided inside the vehicle 1000, and the battery 100 may be provided at a bottom, a head, or a tail of the vehicle 1000. The battery 100 may be used to supply power to the vehicle 1000. For example, the battery 100 may be used as an operation power source of the vehicle 1000. The vehicle 1000 may further include a controller 200 and a motor 300. The controller 200 is used to control the battery 100 to supply power to the motor 300, for example, to satisfy the operation power requirements for starting, navigation and driving of the vehicle 1000.

In some embodiments of this application, the battery 100 may not only be used as an operation power source of the vehicle 1000, but also as a driving power source of the vehicle 1000, providing driving power for the vehicle 1000 in place of, or in combination with, fuel or natural gas.

Refer to FIG. 2. FIG. 2 is a schematic exploded view of a battery provided in some embodiments of this application. The battery 100 includes a casing 10 and a battery cell 20. The battery cell 20 is accommodated in the casing 10. The casing 10 is used to provide an accommodating space for the battery cell 20, and the casing 10 may adopt various structures. In some embodiments, the casing 10 may include a first part 11 and a second part 12. The first part 11 and the second part 12 fit each other. The first part 11 and the second part 12 jointly define the accommodating space for accommodating the battery cell 20. The second part 12 may be a hollow structure with one end open, the first part 11 may be a plate-shaped structure, and the first part 11 fits the open side of the second part 12, so that the first part 11 and the second part 12 jointly define the accommodating space. Alternatively, the first part 11 and the second part 12 may both be hollow structures with one side open, and the open side of the first part 11 fits the open side of the second part 12. Certainly, the casing 10 formed by the first part 11 and the second part 12 may be in various shapes, such as a cylinder or a rectangle.

In the battery 100, a plurality of battery cells 20 may be provided, and the plurality of battery cells 20 may be connected in series, parallel, or series-parallel. The series-parallel connection means that the plurality of battery cells 20 are connected in both series and parallel. The plurality of battery cells 20 may be directly connected in series, parallel, or series-parallel, and then an entirety formed by the plurality of battery cells 20 is accommodated in the casing 10. Certainly, the battery 100 may be an entirety formed by first connecting a plurality of battery cells 20 in series, parallel, or series-parallel to form battery modules, and then connecting the plurality of battery modules in series, parallel, or series-parallel; and the entirety is accommodated in the casing 10. The battery 100 may further include another structure. For example, the battery 100 may include a busbar component for electrical connection between a plurality of battery cells 20, and a battery distribution box connected to the busbar component.

Each battery cell 20 may be a secondary battery or a primary battery; and may be a lithium-sulfur battery, a sodium-ion battery, or a magnesium-ion battery, but is not limited thereto. The battery cell 20 may be cylindrical, flat, rectangle, or the like.

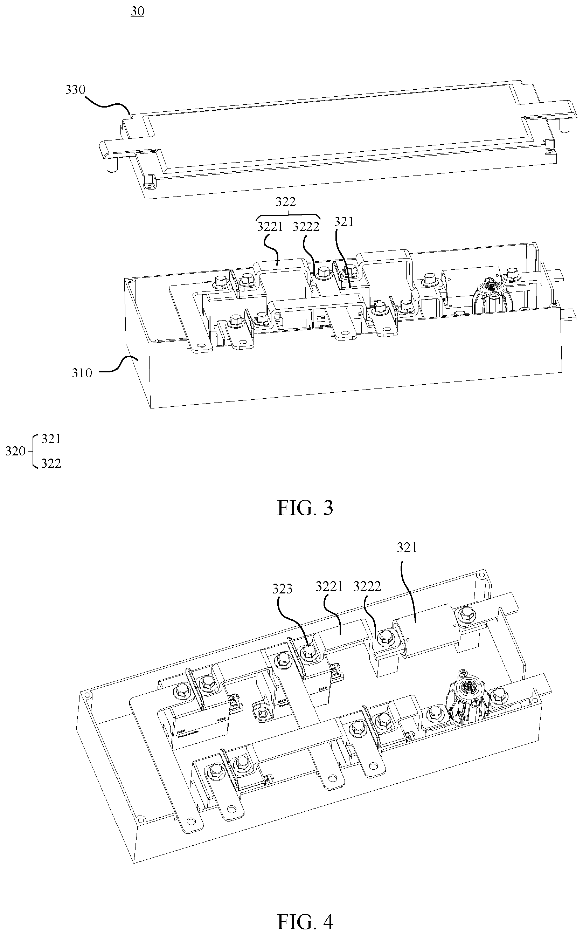

Refer to FIG. 3 and FIG. 4. FIG. 3 is a schematic exploded view of a battery distribution box provided in some embodiments of this application, and FIG. 4 is a schematic structural diagram of an interior of a shell of a battery distribution box according to some embodiments of this application.

The embodiments of this application provide a battery distribution box 30, including a shell 310, an electrical assembly 320, and a heat dissipation cover plate 330. The shell 310 forms an accommodating cavity provided with an opening; the electrical assembly 320 is provided in the accommodating cavity, and the electrical assembly 320 includes a plurality of electrical elements 321 and a conductive connecting member 322 connected to the electrical elements 321; the heat dissipation cover plate 330 is connected to the shell 310 to cover the opening; and the conductive connecting member 322 is at least partially in contact with the heat dissipation cover plate 330 to achieve heat conduction.

The shell 310 may be a square shell with an opening, or a shell of another shape, with an accommodating cavity formed inside. The electrical assembly 320 includes various electrical elements provided in the battery distribution box 30, such as a relay and fuse. The electrical element may be fixedly connected to a bottom or a side wall of the shell 310. The conductive connecting member 322 is a conductive member used to connect different electrical elements, or to connect the electrical elements in the battery distribution box 30 with the outside. The conductive connecting member 322 may be made of conductive metal, such as copper.

The heat dissipation cover plate 330 is a cover plate with a heat dissipation function, which may cover the opening of the shell. The heat dissipation cover plate 330 may be a cover plate with a heat dissipation function, such as a heat dissipation component capable of air cooling or liquid cooling, or a structure or coating with a heat dissipation function, which is not enumerated exhaustively.

The conductive connecting member 322 is at least partially in contact with the heat dissipation cover plate 330, for example, the conductive connecting member 322 is in contact with the heat dissipation cover plate 330 through abutting. The heat dissipation cover plate 330 is provided on a top of the battery distribution box 30. Compared with a heat dissipation component at the bottom of the shell, the conductive connecting member 322 does not extend to the bottom of the shell, thereby reducing the length of the conductive connecting member 322. Moreover, the heat dissipation cover plate 330 is located on the top of the conductive connecting member 322, facilitating contact between the two. The heat dissipation cover plate 330 has good heat dissipation performance, and dissipates heat transferred from the conductive connecting member 322 in a timely manner without occupying a large space inside the battery distribution box 30.

The cover plate is implemented as the heat dissipation cover plate 330, and the conductive connecting member 322 is in contact with the heat dissipation cover plate 330. This simplifies the connection manner between the conductive connecting member 322 and the cover plate having a heat dissipation function, reducing the extension length of the conductive connecting member 322 and improving the space utilization of the battery distribution box 30.

According to some embodiments of this application, as shown in FIG. 3 and FIG. 4, the conductive connecting member 322 includes a connecting portion 3222 and a protruding portion 3221. The connecting portion 3222 is electrically connected to the electrical element 321. The protruding portion 3221 is connected to the connecting portion 3222. The protruding portion 3221 protrudes relative to the connecting portion 3222 toward a side on which the opening of the shell 310 is located. The protruding portion 3221 is in contact with the heat dissipation cover plate 330 to achieve heat conduction.

The connecting portion 3222 may be located at an end of the conductive connecting member 322, and the protruding portion 3221 may be located between the two connecting portions 3222 and protrude relative to the connecting portion 3222 toward the opening of the shell, that is, toward a side on which the heat dissipation cover plate 330 is located.

Due to the connection and arrangement requirements of the electrical element 321, when the heat dissipation cover plate 330 covers the shell 310, a gap is reserved between a lower surface of the heat dissipation cover plate 330 and an upper surface of the electrical element 321 to prevent interference. A height of the protrusion of the protruding portion 3221 is adapted to the gap, so that the protruding portion 3221 contacts an inner surface of the heat dissipation cover plate 330 when the heat dissipation cover plate 330 covers the shell 310, conducting heat generated by excessive current to the heat dissipation cover plate 330 in a timely manner.

With the protruding portion 3221, a heat conduction connection is achieved without additionally occupying the space inside the battery distribution box 30. In this way, the extension structure of the conductive connecting member 322 is simplified.

According to some embodiments of this application, as shown in FIG. 3 and FIG. 4, the connecting portion 3222 is connected to a connection terminal of the electrical element 321, and the connection terminal is located on a surface of the electrical element 321 close to the opening of the shell 310.

The electrical element 321 may be directly or indirectly connected to the bottom surface or side surface of the shell 310 to achieve stable arrangement. The connection terminal of the electrical element 321 may be provided on a surface close to the opening of the shell 310. For example, the connection terminal is located on a respective upper surface of the electrical element 321. In this way, the electrical elements 321 may be positioned first during mounting, then electrical connection is achieved with the conductive connecting member 322, and finally the heat dissipation cover plate 330 covers the opening.

Providing the connection terminal on the surface of the electrical element 321 close to the opening facilitates mounting of various components, especially the conductive connecting member 322, and reduces manufacture and mounting difficulty of the battery distribution box 30.

According to some embodiments of this application, as shown in FIG. 3 and FIG. 4, the connecting portion 3222 and the connection terminal are connected by a fastener 323, and a height of the protruding portion 3221 relative to the connecting portion 3222 is greater than a height of the fastener 323 on the side of the connecting portion 3222 close to the opening of the shell 310.

The fastener 323 may be selected from various types of fasteners, such as various bolts or screws. In some examples, the fastener 323 may be a hexagonal bolt. After the hexagonal bolt is screwed into a threaded hole, a head is located on a side, of the connecting portion 3222 of the conductive connecting member 322, close to the opening. The height of the protruding portion 3221 relative to the connecting portion 3222 is greater than a height of the top of the hexagonal bolt relative to a plane where the upper surface of the connecting portion is located.

In these embodiments, the height of the protruding portion 3221 is limited to avoid structural interference caused by the fastener connection, thereby achieving reliable contact between the protruding portion 3221 and the heat dissipation cover plate 330 and improving the reliability of heat dissipation.

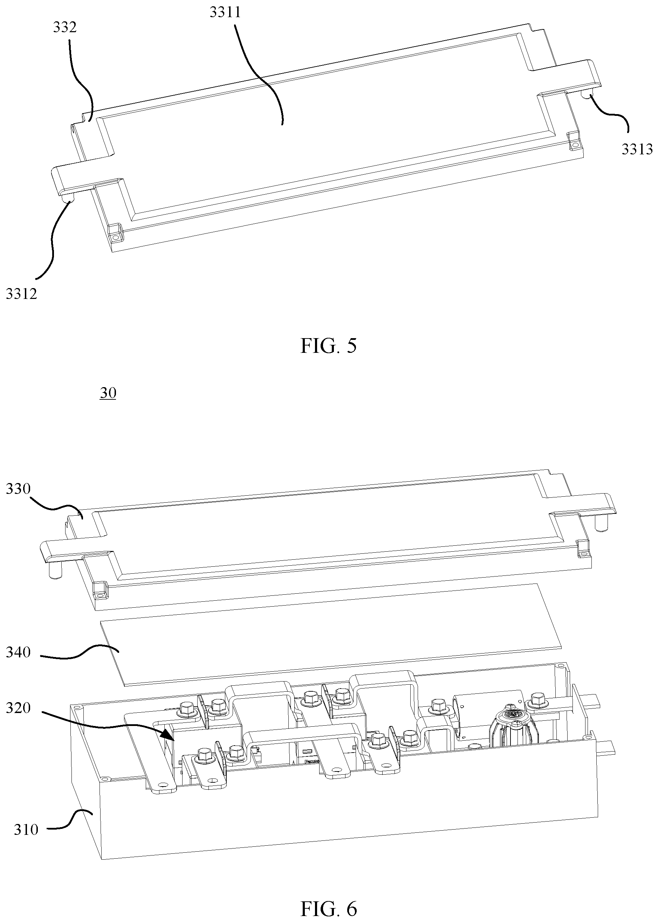

Refer to FIG. 5. FIG. 5 is a schematic structural diagram of a heat dissipation cover plate of a battery distribution box according to some embodiments of this application.

According to some embodiments of this application, as shown in FIG. 5, the heat dissipation cover plate 330 includes a heat dissipation portion 331. The heat dissipation portion 331 includes a heat dissipation body 3311 internally provided with a liquid cooling flow channel and a liquid inlet 3312 and a liquid outlet 3313 that communicate with the liquid cooling flow channel; and the conductive connecting member 322 is at least partially in contact with the heat dissipation body 3311.

The heat dissipation portion 331 may be a liquid cooling component, such as a water cooling plate. One or more liquid cooling flow channels may be provided inside the heat dissipation body 3311 to allow cooling liquid to flow. The liquid inlet 3312 and the liquid outlet 3313 may be respectively located at two ends of the heat dissipation body 3311 and respectively communicating with the liquid cooling flow channel to allow the cooling liquid to enter and exit. In some embodiments, the liquid inlet 3312 and the liquid outlet 3313 of the heat dissipation portion 331 may communicate with a liquid cooling assembly of the battery, and the liquid cooling assembly of the battery and the heat dissipation portion 331 of the battery distribution box 30 may be controlled by a battery management system.

Configuring the heat dissipation portion 331 of the heat dissipation cover plate 330 as a liquid cooling assembly improves the effect of heat dissipation and cooling. The heat dissipation portion 331 may also communicate with the liquid cooling assembly of the battery. This significantly reduces the manufacture costs and simplifies control of the heat dissipation cover plate 330.

According to some embodiments of this application, as shown in FIG. 5, the heat dissipation cover plate 330 further includes a frame 332. The frame 332 is provided around an outer periphery of the heat dissipation portion 331, and the frame 332 is detachably connected to the shell 310.

The frame 332 is a frame-shaped member surrounding the heat dissipation portion 331 and supports the heat dissipation portion 331. A material of the frame 332 may be the same as or different from that of the shell 310.

The heat dissipation cover plate 330 needs to fit and connect with the shell 310, and a corresponding connection structure may be provided on the frame 332. In some embodiments, the frame 332 is provided with a locking structure corresponding to the shell 310, so that the frame 332 and the shell 310 are detachably connected to each other. The locking structure may be a snap connection structure or a threaded connection structure.

The frame 332 is provided to support the heat dissipation portion 331 and is connected to the shell 310. In this way, the structure of the heat dissipation portion 331 is simplified, thereby simplifying processing and saving the manufacture costs.

According to some embodiments of this application, as shown in FIG. 5, the heat dissipation portion 331 and the frame 332 are integrally formed.

The frame 332 may be made of a same material as the heat dissipation portion 331, and the heat dissipation portion 331 with an internal flow channel and the frame 332 with a locking structure may be obtained through integrated manufacture.

Integration of the heat dissipation portion 331 and the frame 332 reduces the number of components, thereby simplifying the assembly and improving production efficiency.

According to some embodiments of this application, as shown in FIG. 5, the heat dissipation portion 331 is a liquid cooling plate, and the frame 332 is configured to be injection molded along an outer periphery of the liquid cooling plate.

To ensure the cooling effect, a material of the liquid cooling plate is metal, such as aluminum, while the frame 332, as a supporting and connecting structure, is not necessarily made of metal, which may lead to an increase in costs and weight. In some embodiments, the frame 332 may be made of plastic. Specifically, the finished liquid cooling plate may be placed in an injection mold and then injection molded along an outer periphery of the liquid cooling plate to obtain an integrated heat dissipation cover plate with a liquid cooling plate in the center and an injection-molded frame 332 on an outer periphery. In some embodiments, the material and structural form of the liquid cooling plate may be the same as those of the liquid cooling plate used in the battery, which reduces manufacture costs.

The injection molding is performed around the liquid cooling plate to obtain the integrated heat dissipation cover plate, so that a tighter connection is formed between the heat dissipation portion 331 and the frame 332. Without affecting the heat dissipation effect, the weight and manufacture costs of the cover plate are reduced, the structure of the cover plate is simplified, and production efficiency is improved.

According to some embodiments of this application, the battery distribution box 30 further includes an insulating layer (not shown in the figure), and the insulating layer is located on a surface of a side of the heat dissipation cover plate 330 in contact with the conductive connecting member 322.

The insulating layer may be a layer of insulating substance formed by spraying or pasting on a surface of a side of the heat dissipation cover plate 330 facing the accommodating cavity, so that electrical leakage is prevented when the conductive connecting member 322 is in contact with the heat dissipation cover plate 330. In some embodiments, the insulating layer may be a film layer formed by directly spraying on a lower surface of the liquid cooling plate used as the heat dissipation portion 331.

With the insulating layer, only heat transfer is achieved when the conductive connecting member 322 is in contact with the heat dissipation cover plate 330, so that the risk of electrical leakage is reduced, and the safety of the battery distribution box 30 is improved to a certain extent.

Refer to FIG. 6. FIG. 6 is a schematic exploded view of a battery distribution box according to other embodiments of this application.

According to some embodiments of this application, the battery distribution box 30 further includes a heat-conducting member 340, and the heat-conducting member 340 is located between the heat dissipation cover plate 330 and the conductive connecting member 322 for heat conduction.

The heat-conducting member 340 may be in a shape of a flat plate and attached to the surface of the side of the heat dissipation cover plate 330 in contact with the conductive connecting member 322. A projection area of the heat-conducting member 340 on the heat dissipation cover plate 330 is much larger than a contact area between the conductive connecting member 322 and the heat dissipation cover plate 330, so that a large amount of heat on the conductive connecting member 322 is dispersed and conducted to the heat dissipation portion 331 for heat dissipation. In some embodiments, the heat-conducting member 340 may be made of an elastic heat-conducting material, to provide a buffer when the conductive connecting member 322 contacts the heat dissipation cover plate 330, which helps maintain the contact state between the conductive connecting member 322 and the heat dissipation cover plate 330 and facilitate control of a fit dimension of the two. For example, the fit dimension of the two may be designed as interference fit. The heat-conducting member 340 may be made of a material with a high thermal conductivity, for example, a metal such as copper and aluminum, graphite, or silicone.

In some embodiments, the heat-conducting member 340 may be a film layer formed on the surface of the heat dissipation cover plate 330 in contact with the conductive connecting member 322 by spraying or coating. For example, an insulating layer and a heat-conducting layer may be sequentially provided on the surface of the heat dissipation cover plate 330 in contact with the conductive connecting member 322.

With the heat-conducting member 340, the contact area between the conductive connecting member 322 and the heat dissipation cover plate 330 is increased, improving the heat conduction efficiency between the conductive connecting member 322 and the heat dissipation cover plate 330 to a certain extent, thereby improving the heat dissipation performance.

According to some embodiments of this application, the heat-conducting member 340 is made of an insulating heat-conducting material.

The heat-conducting member 340 is made of a material with excellent heat conduction and insulation properties, such as alumina ceramic, magnesia ceramic, or silicone rubber. The heat-conducting member 340 may be an insulating heat-conducting film layer formed on the surface of the heat dissipation cover plate 330 for contacting the conductive connecting member 322 by spraying or coating.

The heat-conducting member 340 provides an insulating effect. Therefore, an additional insulating layer is not required, which reduces processes or components.

According to some embodiments of this application, a battery is further provided, including a battery cell and the battery distribution box 30 described in the above embodiments. The battery distribution box 30 is electrically connected to the battery cell.

According to some embodiments of this application, an electric apparatus is further provided. The electric apparatus includes the battery described in the above embodiments, and the battery is used to provide electric energy.

The technical solutions of this application is further described below with reference to a specific embodiment.

As shown in FIG. 3 to FIG. 6, the battery distribution box 30 includes a shell 310, an electrical assembly 320, and a heat dissipation cover plate 330. The shell 310 forms an accommodating cavity provided with an opening; the electrical assembly 320 is provided in the accommodating cavity; the electrical assembly 320 includes a plurality of electrical elements 321 and a conductive connecting member 322 connected to the electrical elements 321; and the heat dissipation cover plate 330 is connected to the shell 310 to cover the opening.

The conductive connecting member 322 includes a connecting portion 3222 and a protruding portion 3221. The connecting portion 3222 is electrically connected to the electrical element 321. The protruding portion 3221 is connected to the connecting portion 3222. The protruding portion 3221 protrudes relative to the connecting portion 3222 toward a side on which the opening is located. The connecting portion 3222 is connected to a connection terminal of the electrical element 321 by a fastener 323. The connection terminal is located on a surface of the electrical element 321 close to the opening. A height of the protruding portion 3221 relative to the connecting portion 3222 is greater than a height of the fastener 323 on a side of the connecting portion 3222 close to the opening.

The heat dissipation cover plate 330 includes a heat dissipation portion 331 and a frame 332. The frame 332 is provided around an outer periphery of the heat dissipation portion 331. The heat dissipation portion 331 is a liquid cooling plate. The frame 332 is injection molded along an outer periphery of the liquid cooling plate.

The heat dissipation portion 331 includes a heat dissipation body 3311 internally provided with a liquid cooling flow channel and a liquid inlet 3312 and a liquid outlet 3313 that communicate with the liquid cooling flow channel. The protruding portion 3221 of the conductive connecting member 322 is in contact with the heat dissipation body 3311.

A surface of the heat dissipation cover plate 330 in contact with the conductive connecting member 322 is sequentially provided with an insulating layer and a heat-conducting layer. In some embodiments, the surface of the heat dissipation cover plate 330 in contact with the conductive connecting member 322 is provided with an insulating heat-conducting layer.

Finally, it should be noted that the above embodiments are only used to illustrate the technical solutions of this application and are not intended to limit this application; although this application has been described in detail with reference to the foregoing embodiments, those of ordinary skill in the art should understand that the technical solutions described in the foregoing embodiments may still be modified, or some or all of the technical features therein may be equivalently replaced; and these modifications or replacements do not cause the essence of the corresponding technical solutions to deviate from the scope of the technical solutions of the embodiments of this application, and they should all be covered by the scope of the claims and the specification of this application. In particular, as long as there is no structural conflict, the technical features mentioned in the embodiments may be combined in any manner. This application is not limited to the specific embodiments disclosed herein, but includes all technical solutions falling within the scope of the claims.

## Claims

1. A battery distribution box, comprising:
a shell, forming an accommodating cavity provided with an opening;
an electrical assembly, provided in the accommodating cavity, wherein the electrical assembly comprises a plurality of electrical elements and a conductive connecting member electrically connected to the electrical elements; and
a heat dissipation cover plate, connected to the shell to cover the opening;
wherein the conductive connecting member is at least partially in contact with the heat dissipation cover plate to achieve heat conduction.

2. The battery distribution box according to claim 1, wherein the conductive connecting member comprises
a connecting portion, wherein the connecting portion is electrically connected to the electrical element; and
a protruding portion, connected to the connecting portion, wherein the protruding portion protrudes relative to the connecting portion toward a side on which the opening of the shell is located, and the protruding portion is in contact with the heat dissipation cover plate to achieve heat conduction.

3. The battery distribution box according to claim 2, wherein the connecting portion is electrically connected to a connection terminal of the electrical element, and the connection terminal is located on a surface of the electrical element close to the opening of the shell.

4. The battery distribution box according to claim 3, wherein the connecting portion and the connection terminal are connected by a fastener, and a height of the protruding portion relative to the connecting portion is greater than a height of the fastener on a side of the connecting portion close to the opening of the shell.

5. The battery distribution box according to any one of claims 1 to 4, wherein the heat dissipation cover plate comprises a heat dissipation portion, and the heat dissipation portion comprises a heat dissipation body internally provided with a liquid cooling flow channel and a liquid inlet and a liquid outlet that communicate with the liquid cooling flow channel; wherein
the conductive connecting member is at least partially in contact with the heat dissipation body.

6. The battery distribution box according to claim 5, wherein the heat dissipation cover plate further comprises a frame, the frame is provided around an outer periphery of the heat dissipation portion, and the frame is detachably connected to the shell.

7. The battery distribution box according to claim 6, wherein the heat dissipation portion and the frame are integrally formed.

8. The battery distribution box according to claim 6 or 7, wherein the heat dissipation portion is a liquid cooling plate, and the frame is injection molded along an outer periphery of the liquid cooling plate.

9. The battery distribution box according to any one of claims 1 to 8, further comprising:
an insulating layer, located on a surface of a side of the heat dissipation cover plate in contact with the conductive connecting member.

10. The battery distribution box according to any one of claims 1 to 8, further comprising:
a heat-conducting member, located between the heat dissipation cover plate and the conductive connecting member for heat conduction.

11. The battery distribution box according to claim 10, wherein the heat-conducting member is made of an insulating heat-conducting material.

12. A battery, comprising
a battery cell, and
the battery distribution box according to any one of claims 1 to 11, wherein the battery distribution box is electrically connected to the battery cell.

13. An electric apparatus, wherein the electric apparatus comprises the battery according to claim 12, and the battery is configured to provide electric energy.
